# EUROPEAN PATENT APPLICATION

(11) **EP 4 567 876 A1**
(43) Date of publication of application: **11.06.2025**
(21) Application number: 23849695.4
(22) Date of filing: 03.04.2023
(51) Int. Cl.: H01L 23/12, H01L 21/60

(54) **SEMICONDUCTOR PACKAGE AND HIGH-FREQUENCY MODULE**

(30) Priority: 03.08.2022 JP 2022124000
(71) Applicant: Fujikura Ltd., Tokyo 135-8512 (JP)
(72) Inventor: TOMITA, Michikazu, Sakura-shi, Chiba 285-8550 (JP)
(74) Representative: Lavoix
(86) International application number: PCT/JP2023/013826
(87) International publication number: WO 2024/029132

(57) **Abstract**

A semiconductor package includes an IC chip, a molded resin, an insulating layer, a plurality of solder bumps, and a plurality of redistribution wirings. The IC chip has a first surface. The molded resin surrounds the IC chip in a plan viewing, has a rectangular or square outer shape in the plan viewing, and has a second surface facing the same direction as the first surface. The insulating layer is formed on the first surface and the second surface. The plurality of solder bumps are formed on the insulating layer. The plurality of redistribution wirings are formed in the insulating layer and connect the IC chip to the plurality of solder bumps. The plurality of solder bumps include a plurality of high-frequency bumps which are connected to high-frequency terminals of the IC chip and through which the same type of high-frequency signal flows. The plurality of high-frequency bumps are disposed at equal distances from a center of the molded resin in the plan viewing.

## Description

### Technical Field

The present invention relates to a semiconductor package and a high-frequency module.

Priority is claimed on Japanese Patent Application No. 2022-124000 filed August 3, 2022, the content of which is incorporated herein by reference.

### Background Art

Patent Document 1 discloses a high-frequency module (semiconductor device) including a semiconductor package (semiconductor chip) and a board. The semiconductor package includes an IC chip (bare chip), an insulating layer, and a plurality of solder bumps connected to the IC chip via redistribution wirings. This semiconductor package is mounted on the board by joining the solder bumps to pads provided on the board.

### Citation List

### Patent Document

Patent Document 1: Japanese Unexamined Patent Application, First Publication No. 2019-186281

### Summary of Invention

### Problem to be Solved by the Invention

Incidentally, in the high-frequency module described in, for example, Patent Document 1, a plurality of elements (for example, antennas, and the like) to which signals are supplied by the IC chip may be mounted on the board. Here, depending on the type of signals supplied by the IC chip, there are cases in which transmission distances between the plurality of elements need to be the same. The transmission distance refers to a length of a transmission path connecting the IC chip and each element. Specifically, each transmission path includes a redistribution wiring, a solder bump, a pad, a wiring within the board, and the like. Therefore, a total value of the lengths needs to be the same between the elements.

However, in the above-described semiconductor package, warping may occur during soldering (during reflow) due to a difference in thermal expansion coefficient or the like between the IC chip and the insulating layer. When such warping occurs in the semiconductor package, a size of a gap between the board and the semiconductor package will not be constant in the in-plane direction. Therefore, there is a likelihood that heights of the solder bumps may vary when the solder solidifies. In this case, a difference in transmission distance occurs between the elements.

The present invention has been made in consideration of such circumstances, and an objective of the present invention is to provide a semiconductor package and a high-frequency module that are capable of suppressing a difference in transmission distance caused by warping.

### Means to Solve the Problem

In order to solve the above-described problems, a semiconductor package according to aspect 1 of the present invention includes an IC chip having a first surface, a molded resin surrounding the IC chip in a plan viewing, having a rectangular or square outer shape in the plan viewing, and having a second surface facing the same direction as the first surface, an insulating layer formed on the first surface and the second surface, a plurality of solder bumps formed on the insulating layer, and a plurality of redistribution wirings formed in the insulating layer and connecting the IC chip to the plurality of solder bumps, in which the plurality of solder bumps include two or more and four or less high-frequency bumps which are connected to high-frequency terminals of the IC chip and through which the same type of high-frequency signal flows, and the two or more and four or less high-frequency bumps are disposed at equal distances from a center of the molded resin in the plan viewing.

According to aspect 1 of the present invention, even if the semiconductor package warps due to a difference in thermal expansion coefficient between the IC chip and the molded resin, and the insulating layer, it is possible to suppress a difference in transmission distance related to the high-frequency bumps.

Also, according to aspect 2 of the present invention, in the semiconductor package of aspect 1, among the plurality of redistribution wirings, redistribution wirings connecting the IC chip to the two or more and four or less high-frequency bumps may have equal lengths.

Also, according to aspect 3 of the present invention, in the semiconductor package of aspect 1 or 2, an outer shape of the IC chip in the plan viewing may be rectangular or square, and a center of the IC chip and the center of the molded resin may coincide in the plan viewing.

Also, according to aspect 4 of the present invention, the semiconductor package of any one of aspects 1 to 3 may have a thickness of 1 mm or less when the solder bump is excluded.

Also, according to aspect 5 of the present invention, in the semiconductor package of any one of aspects 1 to 4, a minimum pitch between the plurality of solder bumps may be 0.3 mm or more.

Also, according to aspect 6 of the present invention, in the semiconductor package of any one of aspects 1 to 5, the two or more and four or less high-frequency bumps may be at positions overlapping the molded resin in the plan viewing.

Also, according to aspect 7 of the present invention, in the semiconductor package of any one of aspects 1 to 6, the plurality of solder bumps may include a plurality of GND bumps connected to GND terminals of the IC chip via the redistribution wiring, the two or more and four or less high-frequency bumps may include a first high-frequency bump and a second high-frequency bump, the plurality of GND bumps may include a plurality of first GND bumps adjacent to the first high-frequency bump in the plan viewing and a plurality of second GND bumps adjacent to the second high-frequency bump in the plan viewing, and a positional relationship between the first high-frequency bump and the plurality of first GND bumps and a positional relationship between the second high-frequency bump and the plurality of second GND bumps may be the same.

Also, according to aspect 8 of the present invention, in the semiconductor package of aspect 7, the plurality of GND bumps may include a GND bump which serves as both the first GND bump and the second GND bump.

Also, a high-frequency module according to aspect 9 of the present invention includes a semiconductor package according to aspect 7 or 8, and a board on which the semiconductor package is mounted, in which the board includes a high-frequency pad joined to the high-frequency bump and a GND pad joined to the GND bump, and a flux is adhered to a portion of the board positioned on a circumferential edge of the high-frequency pad and a portion of the board positioned on a circumferential edge of the GND pad.

### Effects of the Invention

According to the above-described aspects of the present invention, it is possible to provide a semiconductor package and a high-frequency module that are capable of suppressing a difference in transmission distance caused by warping.

### Brief Description of Drawings

[FIG. 1] A plan view of a semiconductor package according to an embodiment of the present invention.
[FIG. 2] A schematic cross-sectional view in a thickness direction illustrating a portion of the semiconductor package according to the embodiment of the present invention.
[FIG. 3] A schematic cross-sectional view in the thickness direction illustrating a portion of a high-frequency module according to the embodiment of the present invention.

### Description of Embodiments

Hereinafter, a semiconductor package and a high-frequency module according to embodiments of the present invention will be described with reference to the drawings.

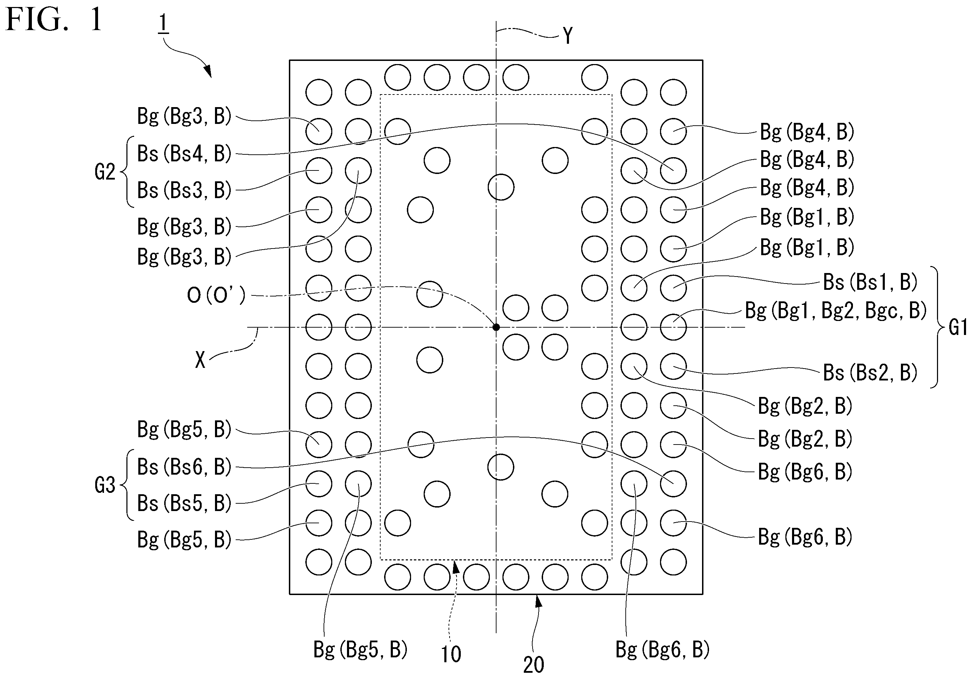

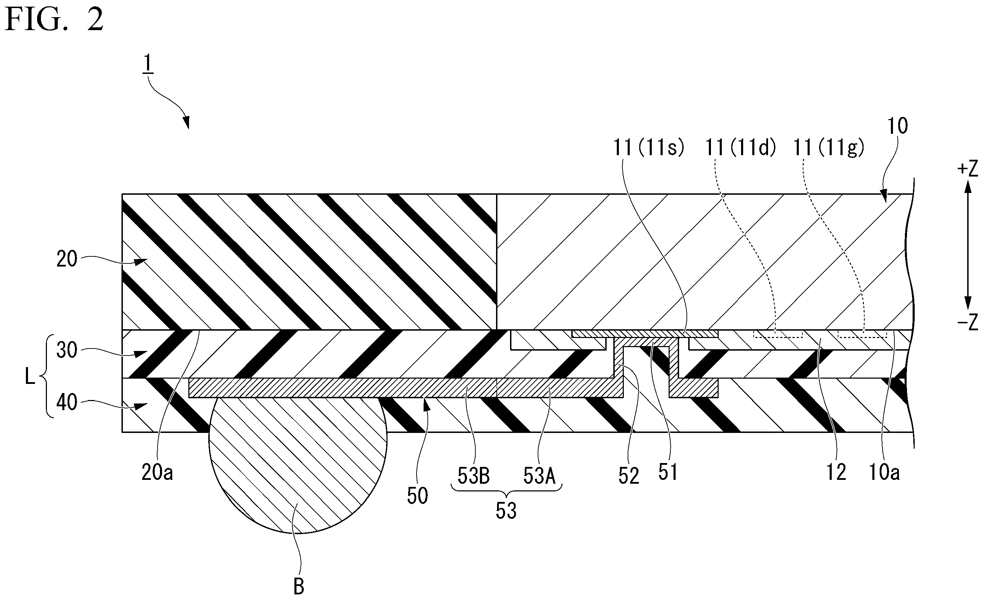

FIG. 1 is a view of a semiconductor package 1 according to the present embodiment from a thickness direction thereof. FIG. 2 is a schematic cross-sectional view in the thickness direction illustrating a portion of the semiconductor package 1.

As illustrated in FIGS. 1 and 2, the semiconductor package 1 includes an IC chip 10, a molded resin 20, an insulating layer L, a plurality of redistribution wirings 50, and a plurality of solder bumps B. As illustrated in FIG. 2, the insulating layer L according to the present embodiment includes a first insulating layer 30 and a second insulating layer 40. A thickness of the semiconductor package 1, excluding the solder bumps B, is 1 mm or less (for example, about 500 µm).

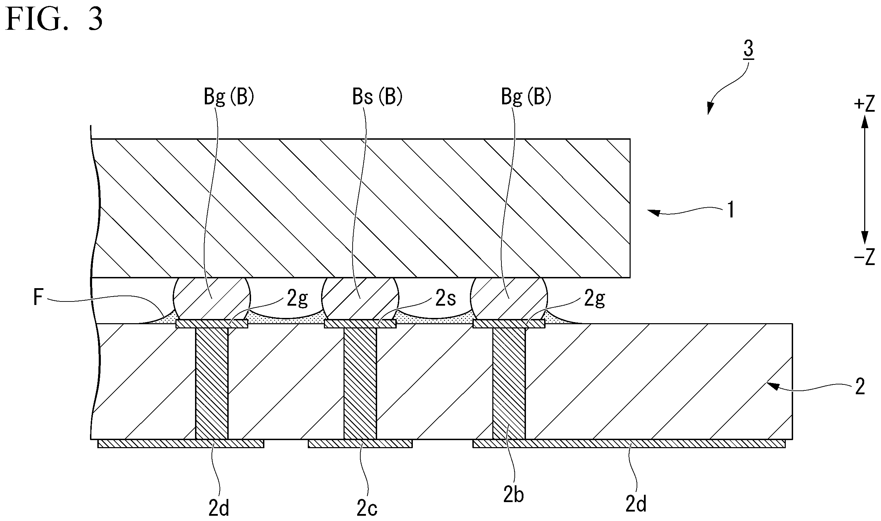

As illustrated in FIG. 3, the semiconductor package 1 is used as a component constituting a high-frequency module 3. The high-frequency module 3 includes a board 2 and the semiconductor package 1 mounted on the board 2. The board 2 has a plurality of pads (such as high-frequency pads 2s and GND pads 2g), and solder bumps B (such as high-frequency bumps Bs and GND bumps Bg, both of which will be described later) are joined to those pads. Thereby, the board 2 and the semiconductor package 1 are electrically connected.

### (Definition of directions)

Viewing the semiconductor package 1 from a thickness direction is referred to as a plan viewing. The thickness direction of the semiconductor package 1 is also a direction in which the insulating layer L and the IC chip 10 face each other. A view in which the semiconductor package 1 is viewed in the plan viewing is referred to as a plan view. As illustrated in FIGS. 2 and 3, the thickness direction is represented by a Z axis. In the thickness direction, a direction from the IC chip 10 toward the insulating layer L is represented as downward or a -Z direction. In the thickness direction, a direction from the insulating layer L toward the IC chip 10 is represented as upward or a +Z direction. Note that, the +Z direction does not need to be upward in a direction of gravity. FIG. 1 is a plan view of the semiconductor package 1 from downside.

As illustrated in FIG. 1, an outer shape of the semiconductor package 1 (molded resin 20) is rectangular in the plan viewing. Therefore, in the semiconductor package 1, it is possible to define a first center line X and a second center line Y that are orthogonal to each other. That is, the semiconductor package 1 has two sides parallel to the first center line X and two sides parallel to the second center line Y. Hereinafter, a direction along the first center line X may be referred to as an X direction, and a direction along the second center line Y may be referred to as a Y direction. A point at which the first center line X and the second center line Y intersect is defined as a center O of the semiconductor package 1 (the molded resin 20) in the plan viewing. The center O of the semiconductor package 1 (the molded resin 20) is also an intersection point of two diagonals of the semiconductor package 1 (the molded resin 20). Note that, in the present specification, the term "rectangle" also includes a case that it is possible to regard as rectangular if manufacturing errors are disregarded.

The IC chip 10 includes a plurality of analog circuits (such as inductors, not illustrated) and is configured to process a high-frequency signal. An outer shape of the IC chip 10 according to the present embodiment is rectangular in the plan viewing. That is, the IC chip 10 has two sides parallel to the X direction and two sides parallel to the Y direction. An intersection point of two diagonals of the IC chip 10 is defined as a center O' of the IC chip 10 in the plan viewing. In the present embodiment, the center O of the semiconductor package 1 (the molded resin 20) and the center O' of the IC chip 10 coincide with each other in the plan viewing. Note that, in the present specification, the term "coincide" also includes a case that it is possible to regard as coinciding if manufacturing errors are disregarded.

The molded resin 20 surrounds the IC chip 10 in the plan viewing. As illustrated in FIG. 2, the IC chip 10 and the molded resin 20 are at the same position in the thickness direction. The IC chip 10 and the molded resin 20 are in contact with each other. As a specific material for the molded resin 20, for example, an epoxy may be used. Also, a filler such as silica may be contained in the molded resin 20. The molded resin 20 has a second surface 20a. In the present embodiment, the second surface 20a is a lower surface (an end surface on a -Z side) of the molded resin 20.

As a manufacturing method for the semiconductor package 1, a so-called fan out wafer level package (FOWLP) may be employed. As a specific example, a plurality of IC chips 10 may be disposed in a grid pattern, gaps between the IC chips 10 may be filled with the molded resin 20, and the molded resin 20 may be cut after the redistribution wirings 50 and the like are formed. According to such a manufacturing method, it is possible to obtain a plurality of semiconductor packages 1 efficiently at a time.

As illustrated in FIG. 2, it is preferable to leave the IC chip 10 exposed without providing the molded resin 20 or the like on an upper surface (an end surface on the +Z side) of the IC chip 10. Thereby, it is possible to improve heat dissipation of the IC chip 10. Alternatively, a structure for improving heat dissipation (such as a heat dissipation sheet or a heat dissipation fin) may be provided on the upper surface of the IC chip 10.

As illustrated in FIG. 2, the IC chip 10 has a first surface 10a. In the present embodiment, the first surface 10a is a lower surface (an end surface on the -Z side) of the IC chip 10. The second surface 20a described above faces in the same direction (downward) as the first surface 10a. A plurality of terminals 11 are provided on the first surface 10a of the IC chip 10. Each of the terminals 11 is, for example, an aluminum pad. It is possible to classify the plurality of terminals 11 into a high-frequency terminal 11s, a GND terminal 11g, a digital signal terminal 11d, and a power supply terminal (not illustrated) according to functions thereof. The high-frequency terminal 11s is the terminal 11 electrically connected to the above-described analog circuits and through which a high-frequency signal flows. The GND terminal 11g is the terminal 11 electrically connected to a GND circuit (not illustrated) of the IC chip 10 and used as a GND potential. The digital signal terminal 11d is the terminal 11 electrically connected to a digital circuit (not illustrated) of the IC chip 10 and through which a digital signal flows. The power supply terminal is the terminal 11 for supplying drive power to each part of the IC chip 10.

As illustrated in FIG. 2, the high-frequency terminal 11s is electrically connected to the solder bump B via the redistribution wiring 50. Although not illustrated, each of other terminals 11 (the GND terminal 11g, the digital signal terminal 11d, and the power supply terminal) is also electrically connected to the solder bump B, via the redistribution wirings 50. In the present specification, the solder bump B connected to the high-frequency terminal 11s is referred to as a "high-frequency bump Bs". The solder bump B connected to the GND terminal 11g is referred to as a "GND bump Bg". The solder bump B connected to the digital signal terminal 11d is referred to as a "digital bump Bd".

Each solder bump B has a substantially spherical shape. Each solder bump B is formed on the insulating layer L. Also, each solder bump B protrudes downward (in the -Z direction) from the second insulating layer 40. As a material for these solder bumps B, SAC305, SAC405, or the like may be employed.

As illustrated in FIG. 2, a passivation film 12 is provided on the lower surface of the IC chip 10. The passivation film 12 is, for example, a nitride film, an oxide film, or the like. The passivation film 12 has a role of protecting the IC chip 10. However, in order to connect the terminal 11 and the redistribution wiring 50, an opening is formed in the passivation film 12 at a portion overlapping the terminal 11.

The first insulating layer 30 is laminated on the IC chip 10 and the second surface 20a (a lower surface (an end surface on the -Z side)) of the molded resin 20. The second insulating layer 40 is laminated on a lower surface (an end surface on the -Z side) of the first insulating layer 30. That is, the insulating layer L is formed on the first surface 10a (lower surface) of the IC chip 10 and the second surface 20a (lower surface) of the molded resin 20. In other words, the insulating layer L overlaps the IC chip 10 and the molded resin 20 in the plan viewing. As a material of the first insulating layer 30 and the second insulating layer 40, for example, a transparent resin (such as, for example, polyimide) may be suitably used. Note that, the insulating layer L may have a single-layer structure or may have a structure with three or more layers.

The redistribution wiring 50 is formed in the insulating layer L. As a material of the redistribution wiring 50, for example, copper may be employed. The redistribution wiring 50 has a terminal joint portion 51, a through portion 52, and an extension portion 53. The terminal joint portion 51 is joined to the terminal 11. The through portion 52 extends downward (in the -Z direction) from the terminal joint portion 51 and penetrates the first insulating layer 30 in the thickness direction. The extension portion 53 extends in a direction (in-plane direction) orthogonal to the thickness direction. The extension portion 53 is disposed to span across a boundary between the IC chip 10 and the molded resin 20 in the plan viewing. Hereinafter, a portion of the extension portion 53 that overlaps the IC chip 10 in the plan viewing is referred to as a fan-in portion 53A, and a portion thereof that overlaps the molded resin 20 in the plan viewing is referred to as a fan-out portion 53B. In the example of FIG. 2, the solder bump B is joined to the fan-out portion 53B of the extension portion 53. Thereby, it is possible to connect the solder bump B (the high-frequency bump Bs) disposed at a position overlapping the molded resin 20 in the plan viewing to the terminal 11 (the high-frequency terminal 11s). However, a shape of the redistribution wiring 50 may be changed as appropriate. For example, the redistribution wiring 50 that connects the solder bump B overlapping the IC chip 10 in the plan viewing and the terminal **11** may not have the fan-out portion 53B.

As illustrated in FIG. 1, the semiconductor package 1 according to the present embodiment has six high-frequency bumps Bs consisting of a first high-frequency bump Bs1 to a sixth high-frequency bump Bs6. Also, the six high-frequency bumps Bs consist of three groups: a first high-frequency bump group G1, a second high-frequency bump group G2, and a third high-frequency bump group G3. The first high-frequency bump group G1 includes the first high-frequency bump Bs1 and the second high-frequency bump Bs2. The second high-frequency bump group G2 includes the third high-frequency bump Bs3 and the fourth high-frequency bump Bs4. The third high-frequency bump group G3 includes the fifth high-frequency bump Bs5 and the sixth high-frequency bump Bs6.

Also, the same type of high-frequency signal is flowed through two high-frequency bumps Bs included in each of the high-frequency bump groups G1 to G3. For example, local signals (differential signal) are flowed through the two high-frequency bumps Bs (the first high-frequency bump Bs1 and the second high-frequency bump Bs2) included in the first high-frequency bump group G1. V-polarized waves are flowed through the two high-frequency bumps Bs (the third high-frequency bump Bs3 and the fourth high-frequency bump Bs4) included in the second high-frequency bump group G2. H-polarized waves are flowed through the two high-frequency bumps Bs (the fifth high-frequency bump Bs5 and the sixth high-frequency bump Bs6) included in the third high-frequency bump group G3.

Here, in the present embodiment, the high-frequency bumps Bs through which the same type of signal flows are disposed equidistant from the center O of the molded resin 20 in the plan viewing. For example, the first high-frequency bump Bs1 and the second high-frequency bump Bs2 are disposed symmetrically with respect to the first center line X, and are thereby disposed equidistant from the center O. Similarly, the third high-frequency bump Bs3 and the fourth high-frequency bump Bs4 are disposed symmetrically with respect to the second center line Y, and are thereby disposed equidistant from the center O. Also, the fifth high-frequency bump Bs5 and the sixth high-frequency bump Bs6 are disposed symmetrically with respect to the second center line Y, and are thereby disposed equidistant from the center O. Note that, a distance from the center O to the high-frequency bump Bs is defined as a length of a straight line connecting the center O and a center of the high-frequency bump Bs in the plan viewing. Also, in the present specification, the terms "equidistant" and "symmetrical" include cases of equidistant and symmetrical if manufacturing errors are disregarded.

Also, the high-frequency bump Bs is preferably surrounded by a plurality of GND bumps Bg in the plan viewing. In the present embodiment, as illustrated in FIG. 1, three GND bumps Bg are adjacent to each high-frequency bump Bs in the plan viewing. For example, the GND bumps Bg are disposed one each to the left of, above, and below the first high-frequency bump Bs1 in the figure. Hereinafter, these three GND bumps Bg adjacent to the first high-frequency bump Bs1 will be referred to as first GND bumps Bg1. According to this disposition, the GND bumps Bg function as a shield. Thereby, it is possible to suppress noise emitted from the high-frequency bump Bs, or noise in the space affecting the high-frequency signal flowing through the high-frequency bump Bs. Note that, the number of GND bumps Bg adjacent to one high-frequency bump Bs may be changed as appropriate. However, it is desirable that three or more GND bumps Bg be adjacent to one high-frequency bump Bs.

Also, in the present embodiment, a positional relationship between the high-frequency bump Bs and the three adjacent GND bumps Bg is common to all the high-frequency bumps Bs. Here, the "positional relationship between the high-frequency bump Bs and the three adjacent GND bumps Bg" means a relative position of each GND bump Bg as viewed from the high-frequency bump Bs. In addition, the phrase "a positional relationship is common" also includes cases in which it is possible to regard positional relationships as common if rotation, inversion, and manufacturing errors are disregarded.

For example, the GND bumps Bg (hereinafter, referred to as the second GND bumps Bg2) are disposed one each to the left of, above, and below the second high-frequency bump Bs2 in the figure, as in the first high-frequency bump Bs1. Disposition of the second GND bumps Bg2 with respect to the second high-frequency bump Bs2 coincides with disposition of the first GND bumps Bg1 with respect to the first high-frequency bump Bs1. Similarly, three GND bumps Bg (hereinafter referred to as fourth GND bumps Bg4) are adjacent to the fourth high-frequency bump Bs4, and three GND bumps Bg (hereinafter referred to as sixth GND bumps Bg6) are adjacent to the sixth high-frequency bump Bs6. Disposition of the fourth GND bumps Bg4 with respect to the fourth high-frequency bump Bs4 coincides with disposition of the GND bumps Bg1 with respect to the first high-frequency bump Bs1. Disposition of the sixth GND bumps Bg6 with respect to the sixth high-frequency bump Bs6 coincides with disposition of the first GND bumps Bg1 with respect to the first high-frequency bump Bs1.

Also, the GND bumps Bg (hereinafter referred to as the third GND bumps Bg3) are disposed one each to the right of, above, and below the third high-frequency bump Bs3 in the figure. Disposition of the third GND bumps Bg3 with respect to the third high-frequency bump Bs3, when rotated by 180°, coincides with disposition of the first GND bump Bg1 with respect to the first high-frequency bump Bs1. Similarly, three GND bumps Bg (hereinafter referred to as fifth GND bumps Bg5) are adjacent to the fifth high-frequency bump Bs5. Disposition of the fifth GND bump Bg5 with respect to the fifth high-frequency bump Bs5, when rotated by 180°, coincides with disposition of the first GND bump Bg1 with respect to the first high-frequency bump Bs1.

Also, in the present embodiment, the first high-frequency bump Bs1 and the second high-frequency bump Bs2 share one GND bump Bg. That is, there is the GND bump Bg (hereinafter referred to as a common GND bump Bgc) that serves as both the first GND bump Bg1 and the second GND bump Bg2.

In the present embodiment, lengths of two redistribution wirings 50 connecting two high-frequency bumps Bs included in each of the high-frequency bump groups G1 to G3 to the IC chip 10 are substantially equal to each other. For example, a length of the redistribution wiring 50 connecting the IC chip 10 to the first high-frequency bump Bs1 and a length of the redistribution wiring 50 connecting the IC chip 10 to the second high-frequency bump Bs2 are substantially equal to each other. Note that, in the present specification, the phrase "substantially equal" also includes a case that it is possible to regard as equal if manufacturing errors (about 10 µm) are disregarded.

As illustrated in FIG. 3, a plurality of via holes 2b are formed in the board 2. The via holes 2b may each be a through-hole via. Also, pads (the high-frequency pad 2s, the GND pads 2g, and the like) are formed on the via holes 2b. That is, a so-called pad-on-via structure is employed. The high-frequency pad 2s is joined to the high-frequency bump Bs, and the GND pad 2g is joined to the GND bump Bg. The GND pad 2g is connected to a GND layer 2d of the board 2 through the via hole 2b.

The high-frequency pad 2s according to the present embodiment is connected to an antenna 2c (such as, for example, a patch antenna) through the via hole 2b. The high-frequency module 3 according to the present embodiment may also be called an antenna module. As illustrated in FIGS. 2 and 3, the IC chip 10 supplies a high-frequency signal to the antenna 2c through the redistribution wiring 50, the solder bump B (the high-frequency bump Bs), the high-frequency pad 2s, and the via hole 2b. In other words, a transmission path connecting the IC chip 10 and the antenna 2c includes the redistribution wiring 50, the high-frequency bump Bs, the high-frequency pad 2s, and the via hole 2b. A material of the board 2 may be, for example, a high-frequency material such as, for example, modified polyphenylene ether (PPE).

Also, the semiconductor package 1 according to the present embodiment may be mounted on the board 2 by a surface mount technology (SMT). In this case, a minimum pitch between the plurality of solder bumps B is preferably 0.3 mm or more. The "pitch" refers to a distance between centers of adjacent solder bumps B. The "minimum pitch between the solder bumps B" refers to a minimum value of the pitch between the solder bumps B. When the minimum pitch is set to 0.3 mm or more, it is possible to stabilize formation of the high-frequency pads 2s, the GND pads 2g, and the like on the board 2 and it is possible to improve a positioning accuracy in SMT. Also, when the minimum pitch is increased, it is possible to reduce a degree of difficulty in designing the board 2, and therefore it is possible to achieve cost reduction. Note that, the minimum pitch is more preferably 0.4 mm or more. In this case, it is possible to further reduce a degree of difficulty in mounting by SMT, and therefore it is possible to further reduce design costs of the board 2.

More specifically, the semiconductor package 1 according to the present embodiment may be mounted on the board 2 using the following method. First, an application step is performed. In the application step, a paste in which flux F and particulate solder are mixed is applied onto the pads 2g and 2s. Next, a placement step is performed. In the placement step, the board 2 is disposed so that the pads 2g and 2s face upward. Then, the semiconductor package 1 is placed on the board 2 so that the pads 2g and 2s come into contact with the bumps Bg and Bs, respectively. Next, a heating step (reflow step) is performed. In the heating step, the semiconductor package 1 and the board 2 are heated (reflowed). Thereby, the bumps Bg and Bs and solder particles in the paste are melted, and the bumps Bg and Bs and the solder particles in the paste are integrated together. Finally, a cooling step is performed. In the cooling step, the semiconductor package 1 and the board 2 are cooled to solidify the solder. Thereby, the pads 2g and 2s are respectively joined to the bumps Bg and Bs. Through these steps, the semiconductor package 1 is mounted on the board 2, and thereby the high-frequency module 3 as illustrated in FIG. 3 is obtained.

Here, in the cooling step described above, the flux F remains around circumferential edges of the bumps Bg and Bs to adhere to the board 2 as illustrated in FIG. 3. Generally, the flux F is a dielectric material. Therefore, the flux F adhering to the board 2 affects characteristics of the high-frequency signal flowing through the high-frequency bumps Bs. Therefore, in the semiconductor package 1 according to the present embodiment, as described above, the positional relationship between the high-frequency bump Bs and the GND bumps Bg surrounding it is common to all the high-frequency bumps Bs. Therefore, for all the high-frequency bumps Bs, it is possible to make a shape of the flux F adhering around the high-frequency bump Bs the same. Thereby, it is possible to equalize an effect of the flux F on the high-frequency signal between the high-frequency bumps Bs, and therefore it is possible to suppress an increase in variation of high-frequency characteristics. For the reasons described above, in the high-frequency module 3 according to the present embodiment, it is possible to omit a cleaning step while minimizing adverse effects on the high-frequency signal. The cleaning step is a step of removing the flux F from a surface of the board 2. It is possible to reduce operation costs by omitting the cleaning step.

Also, when the above-described steps are completed, lengths of the two transmission paths corresponding to the two high-frequency bumps Bs belonging to each of the high-frequency bump groups G1 to G3 are substantially equal to each other. For example, a length of the transmission path extending from the IC chip 10 through the third high-frequency bump Bs3 to the antenna 2c and a length of the transmission path extending from the IC chip 10 through the fourth high-frequency bump Bs4 to the antenna 2c are substantially equal to each other. The principle by which the transmission distances become substantially equal in this way will be described below. However, for ease of explanation, the transmission path related to the third high-frequency bump Bs3 and the transmission path related to the fourth high-frequency bump Bs4 will be used as representative examples, and the principle by which these lengths become substantially equal will be described.

As described above, the redistribution wiring 50 connecting the IC chip 10 and the third high-frequency bump Bs3 and the redistribution wiring 50 connecting the molded resin 20 and the fourth high-frequency bump Bs4 have the same length. Also, it is possible to regard a length of the via hole 2b formed in the board 2 and a thickness of the high-frequency pad 2s as constant. Therefore, making the lengths of the two transmission paths equal is equivalent to making sizes (heights) of the high-frequency bumps Bs3 and Bs4 equal.

Heights of the high-frequency bumps Bs3 and Bs4 when the high-frequency module 3 is completed depends on a distance between the semiconductor package 1 and the board 2 immediately before the above-described cooling step. That is, if the distance between the semiconductor package 1 and the board 2 is small, the heights of the high-frequency bumps Bs3 and Bs4 will become small, and if the distance is large, the heights of the high-frequency bumps Bs3 and Bs4 will become large. Therefore, ideally, it is desirable that the distance between the semiconductor package 1 and the board 2 be constant over the entire semiconductor package 1 immediately before the cooling step. However, there is a difference in thermal expansion coefficient between the IC chip 10 and the molded resin 20, and the insulating layer L. Therefore, warping occurs in the semiconductor package 1 during the heating step. Therefore, the distance between the semiconductor package 1 and the board 2 tends to become uneven in the in-plane direction.

Then, in the semiconductor package 1 according to the present embodiment, the third high-frequency bump Bs3 and the fourth high-frequency bump Bs4 are disposed at equal distances from the center O of the semiconductor package 1 in the plan viewing. It is considered that the semiconductor package 1 warps symmetrically with respect to the center O during the heating step. Therefore, even if warping occurs in the semiconductor package 1, it is possible to suppress a difference between the distance between the semiconductor package 1 and the board 2 at a position of the third high-frequency bump Bs3 and the distance between the semiconductor package 1 and the board 2 at a position of the fourth high-frequency bump Bs4. Therefore, it is possible to suppress a difference in size (height) between the third high-frequency bump Bs3 and the fourth high-frequency bump Bs4, and it is possible to suppress a difference in length between the transmission path related to the third high-frequency bump Bs3 and the transmission path related to the fourth high-frequency bump Bs4. By the same principle, it is possible to suppress a difference in length between the transmission path related to the fifth high-frequency bump Bs5 and the transmission path related to the sixth high-frequency bump Bs6. Also, although the first high-frequency bump Bs1 and the second high-frequency bump Bs2 are high-frequency bumps Bs that constitute transmission paths for a local signal (differential signal), by the same principle, it is possible to suppress a difference in length between the transmission path related to the first high-frequency bump Bs1 and the transmission path related to the second high-frequency bump Bs2.

As described above, the semiconductor package 1 of the present embodiment includes the IC chip 10 having the first surface 10a, the molded resin 20 surrounding the IC chip 10 in the plan viewing, having a rectangular outer shape in the plan viewing, and having the second surface 20a facing the same direction as the first surface 10a, the insulating layer L formed on the first surface 10a and the second surface 20a, the plurality of solder bumps B formed on the insulating layer L, and the plurality of redistribution wirings 50 formed in the insulating layer L and connecting the IC chip 10 to the plurality of solder bumps B, in which the plurality of solder bumps B include two high-frequency bumps Bs1 and Bs2 which are connected to the high-frequency terminals 11s of the IC chip 10 and through which the same type of high-frequency signal flows, and the high-frequency bumps Bs1 and Bs2 are disposed at equal distances from the center O of the molded resin 20 in the plan viewing.

With this configuration, even if the semiconductor package 1 warps due to a difference in thermal expansion coefficient between the IC chip 10 and the molded resin 20, and the insulating layer L, it is possible to suppress a difference in transmission distance related to the high-frequency bumps Bs.

Also, an outer shape of the IC chip 10 in the plan viewing is rectangular, and the center O' of the IC chip 10 and the center O of the molded resin 20 coincide in the plan viewing. With this configuration, it is possible to improve a symmetry of warping of the semiconductor package 1, and it is possible to suppress the difference in transmission distance more reliably.

Also, a thickness of the semiconductor package 1 according to the present embodiment, excluding the solder bump B, may be 1 mm or less. When the thickness of the semiconductor package 1 is small in this manner, the semiconductor package 1 is likely to warp. However, when the semiconductor package 1 has the characteristics described above, it is possible to effectively suppress a difference in transmission distance.

Also, a minimum pitch between the plurality of solder bumps B may be 0.3 mm or more. According to this configuration, it is possible to stabilize formation of pads on the board 2 and it is possible to improve a positioning accuracy in SMT. Also, when the minimum pitch is increased, it is possible to reduce a degree of difficulty in designing the board 2, and thereby it is possible to achieve cost reduction.

Also, the plurality of solder bumps B include the plurality of GND bumps Bg connected to the GND terminals 11g of the IC chip 10 via the redistribution wiring 50, the two high-frequency bumps Bs include the first high-frequency bump Bs1 and the second high-frequency bump Bs2, the plurality of GND bumps Bg include the plurality of first GND bumps Bg1 adjacent to the first high-frequency bump Bs1 in the plan viewing and the plurality of second GND bumps Bg2 adjacent to the second high-frequency bump Bs2 in the plan viewing, and a positional relationship between the first high-frequency bump Bs1 and the plurality of first GND bumps Bg1 and a positional relationship between the second high-frequency bump Bs2 and the plurality of second GND bumps Bg2 may be the same. When the high-frequency module 3 is manufactured by mounting the semiconductor package 1 having the above configuration on the board 2, it is possible to make shapes of the flux F adhering around the high-frequency bumps Bs1 and Bs2 the same. Thereby, it is possible to equalize an effect of the flux F on the high-frequency signal between the high-frequency bumps Bs, and therefore it is possible to suppress an increase in variation of the high-frequency characteristics.

Also, the plurality of GND bumps Bg may include the GND bump Bg (common GND bump Bgc) that serves as both the first GND bump Bg1 and the second GND bump Bg2. According to this configuration, it is easier to achieve reduction in size of the semiconductor package 1.

Also, the high-frequency module 3 according to the present embodiment includes the above-described semiconductor package 1 and the board 2 on which the semiconductor package 1 is mounted, in which the board 2 includes the high-frequency pad 2s joined to the high-frequency bump Bs and the GND pad 2g joined to the GND bump Bg, and the flux F is adhered to a portion of the board 2 positioned on a circumferential edge of the high-frequency pad 2s and a portion of the board 2 positioned on a circumferential edge of the GND pad 2g. With this configuration, it is possible to make shapes of the flux F adhering around the high-frequency bumps Bs1 and Bs2 the same. Thereby, it is possible to equalize an effect of the flux F on the high-frequency signal between the high-frequency bumps Bs, and therefore it is possible to suppress an increase in variation of the high-frequency characteristics.

Note that, the technical scope of the present invention is not limited to the above-described embodiment, and various modifications may be made in a range not departing from the spirit of the present invention.

For example, an outer shape of the molded resin 20 may be a square in the plan viewing. Similarly, an outer shape of the IC chip 10 may be a square in the plan viewing. That is, each of outer shapes of the IC chip 10 and the molded resin 20 need only be rectangular. Note that, in the present specification, the term "square" also includes a case that it is possible to regard as a square if manufacturing errors are disregarded.

Also, the number of the high-frequency bumps Bs included in each of the high-frequency bump groups G1 to G3 may be three or four. In other words, there may be three or four high-frequency bumps Bs through which the same type of high-frequency signal flows. Even in this case, when distances from the high-frequency bumps Bs to the center O of the molded resin 20 are made equal in each of the high-frequency bump groups G1 to G3, it is possible to obtain the same operation and effects as those of the above-described embodiment. Also, the number of high-frequency bump groups may also be changed appropriately.

Also, in the above-described embodiment, it has been described that the positional relationship between the high-frequency bump Bs and the GND bumps Bg is the same for all the high-frequency bumps Bs, but the positional relationship between the high-frequency bump Bs and the GND bumps Bg is not limited thereto. For example, a positional relationship between the bumps Bs and Bg in some high-frequency bump groups having different functions (for example, through which an LO signal is flowed) may be different from a positional relationship between the bumps Bs and Bg in other high-frequency bump groups.

Also, in the above-described embodiment, the first high-frequency bump Bs1 and the second high-frequency bump Bs2 have shared the GND bump Bg, but the high-frequency bumps Bs1 to Bs6 may be disposed so that the third high-frequency bump Bs3 and the fourth high-frequency bump Bs4 share the GND bump Bg. Alternatively, the high-frequency bumps Bs1 to Bs6 may be disposed so that the fifth high-frequency bump Bs5 and the sixth high-frequency bump Bs6 share the GND bump Bg.

Also, as long as it is possible to keep the transmission distance from the IC chip 10 to the antenna 2c constant, lengths of the redistribution wirings 50 may be different.

Also, the center O of the molded resin 20 and the center O' of the IC chip 10 do not necessarily have to coincide in the plan viewing.

Also, an underfill may be applied between the semiconductor package 1 and the board 2. The underfill may contain fillers such as epoxy or silica. In this case, it is possible to increase a mechanical strength of the connection between the IC chip 10 and the molded resin 20.

In addition, the components in the above-described embodiment may be appropriately replaced with well-known components within a range not departing from the spirit of the present invention, and the above-described embodiment and modified example may be appropriately combined.

### Reference Signs List

1 Semiconductor package
2 Board
2s High-frequency pad
2g GND pad
3 High-frequency module
10 IC Chip
10a First surface
11s High-frequency terminal
11g GND terminal
20 Molded resin
20a Second surface
50 Redistribution wiring
B Solder bump
Bs High-frequency bump
Bs1 First high-frequency bump
Bs2 Second high-frequency bump
Bg GND bump
Bg1 First GND bump
Bg2 Second GND bump
L Insulating layer
O Center of molded resin
O' Center of IC chip
F Flux

## Claims

1. A semiconductor package comprising:
an IC chip having a first surface;
a molded resin surrounding the IC chip in a plan viewing, having a rectangular or square outer shape in the plan viewing, and having a second surface facing the same direction as the first surface;
an insulating layer formed on the first surface and the second surface;
a plurality of solder bumps formed on the insulating layer; and
a plurality of redistribution wirings formed in the insulating layer and connecting the IC chip to the plurality of solder bumps, wherein
the plurality of solder bumps include two or more and four or less high-frequency bumps which are connected to high-frequency terminals of the IC chip and through which the same type of high-frequency signal flows, and
the two or more and four or less high-frequency bumps are disposed at equal distances from a center of the molded resin in the plan viewing.

2. The semiconductor package according to claim 1, wherein among the plurality of redistribution wirings, redistribution wirings connecting the IC chip to the two or more and four or less high-frequency bumps have equal lengths.

3. The semiconductor package according to claim 1 or 2, wherein
an outer shape of the IC chip in the plan viewing is rectangular or square, and
a center of the IC chip and the center of the molded resin coincide in the plan viewing.

4. The semiconductor package according to any one of claims 1 to 3, having a thickness of 1 mm or less when the solder bump is excluded.

5. The semiconductor package according to any one of claims 1 to 4, wherein a minimum pitch between the plurality of solder bumps is 0.3 mm or more.

6. The semiconductor package according to any one of claims 1 to 5, wherein the two or more and four or less high-frequency bumps are at positions overlapping the molded resin in the plan viewing.

7. The semiconductor package according to any one of claims 1 to 6, wherein
the plurality of solder bumps include a plurality of GND bumps connected to GND terminals of the IC chip via the redistribution wiring,
the two or more and four or less high-frequency bumps include a first high-frequency bump and a second high-frequency bump,
the plurality of GND bumps include a plurality of first GND bumps adjacent to the first high-frequency bump in the plan viewing and a plurality of second GND bumps adjacent to the second high-frequency bump in the plan viewing, and
a positional relationship between the first high-frequency bump and the plurality of first GND bumps and a positional relationship between the second high-frequency bump and the plurality of second GND bumps are the same.

8. The semiconductor package according to claim 7, wherein the plurality of GND bumps include a GND bump which serves as both the first GND bump and the second GND bump.

9. A high-frequency module comprising:
a semiconductor package according to claim 7 or 8; and
a board on which the semiconductor package is mounted, wherein
the board includes a high-frequency pad joined to the high-frequency bump and a GND pad joined to the GND bump, and
a flux is adhered to a portion of the board positioned on a circumferential edge of the high-frequency pad and a portion of the board positioned on a circumferential edge of the GND pad.
